# EUROPEAN PATENT SPECIFICATION

(11) **EP 3 005 851 B1**
(45) Date of publication and mention of the grant of the patent: **15.07.2020**
(21) Application number: 13811285.9
(22) Date of filing: 25.11.2013
(51) Int. Cl.: H05K 7/20

(54) **HOUSING HAVING CONFIGURABLE AIRFLOW EXHAUST**
GEHÄUSE MIT KONFIGURIERBARER ABLUFT.
BOÎTIER AYANT ÉCHAPPEMENT D'AIR CONFIGURABLE

(30) Priority: 28.11.2012 US 201213687517
(43) Date of publication of application: 13.04.2016
(73) Proprietor: Eaton Corporation, Cleveland, OH 44122 (US)
(72) Inventor: HOGLUND, Justin, Raymond, Wake Forest, NC 27587 (US)
(74) Representative: Emde, Eric
(86) International application number: PCT/US2013/071564
(87) International publication number: WO 2014/085280

(56) References cited:
- JP-A- H0 529 782
- US-A1- 2008 266 789
- US-A1- 2011 175 505
- US-B1- 6 611 428

## Description

### FIELD OF INVENTION

The present disclosure relates to a cabinet for articles that require cooling. More particularly, the present disclosure relates to a cabinet having a configurable airflow exhaust for articles that require cooling.

### BACKGROUND

Cabinets or other housings are used to house electrical equipment and other articles that require cooling. In certain cases, users of the articles prefer to exhaust heated air through the top of the cabinet. For example, the user may desire to place the rear of a cabinet flush against a wall, or near a heat sensitive object. In other cases, users of the articles prefer to exhaust heated air through the rear of the cabinet. For example, the user may desire to space the cabinet away from a wall.

US 6,611,428 B1 discloses a cabinet for cooling electronic modules, the cabinet including a first side panel, a second side panel, a front panel and a rear panel. A plurality of chassis is encompassed by the plurality of outer panels, wherein the plurality of chassis and the first side panel define a first interspace region, and wherein the plurality of chassis and the second side panel define a second interspace region. A plurality of electronic modules is coupled to each of the plurality of chassis, where the plurality of electronic modules are substantially horizontally disposed within each of the plurality of chassis, and wherein at least a portion of the plurality of electronic modules produce more than 150 Watts of thermal energy each. An air moving apparatus draws cooling air external to the cabinet into the first interspace region, wherein the cooling air passes over the plurality of electronic modules in a substantially horizontal manner and substantially parallel to the front panel and the rear panel, wherein the cooling air subsequently enters the second interspace region and is thereafter exhausted from the cabinet.

US 2008/266789 A1 discloses a telecommunications cabinet in which active equipment can be mounted. The cabinet including an airflow ducting arrangement located in the interior region of the cabinet. The airflow ducting arrangement accommodating thermal cooling of active equipment having internal side-to-side air cooling arrangements.

US 2011/175505 A1 discloses adjustable blanking panels for use with equipment racks and enclosures to cover or fill in vacant sections of the rack or enclosure, to prevent the circular flow and re-entry of high temperature air into the intake of electrical and computer equipment. The adjustable blanking panels include a generally rectangular base frame that defines opposing left and right side channels, and a generally rectangular shield that is adapted to be inserted into the side channels and slide relative to the base frame, to adjust the height of the panel to the size of the vacant section. The adjustable blanking panel may further include a lip that may be used to raise or lower the shield.

JP H05-29782 A discloses a forced air cooling system for use in electronic devices whereby upon the system being interrupted owing to trouble of an air cooling fan an opening part of such a device is automatically more opened to facilitate heat dissipation from internal electric circuit parts of the electric device. In an outer box including a fan provided on the side thereof, a plurality of openings are provided in the surface of the outer box, and, among the openings, in the openings on the side thereof where the fan is provided there is provided a cover which is closed owing to suction of air caused by the rotation of the fan. The cover is opened toward the outside of the outer box upon the interruption of the rotation of the fan by the operation of a spring provided between a surface plate of the outer box and the cover. Thus, heaters accommodated in the outer box are air-cooled.

### SUMMARY OF THE INVENTION

In one embodiment, a cabinet is configured to house an article that requires cooling and is provided as set forth in claim 1.

In another embodiment, a cabinet is configured to house an article that requires cooling and is provided as set forth in claim 5. Preferred embodiments of the present invention may be gathered from the dependent claims.

### BRIEF DESCRIPTION OF DRAWINGS

In the accompanying drawings, structures are illustrated that, together with the detailed description provided below, describe exemplary embodiments of the claimed invention. Like elements are identified with the same reference numerals. It should be understood that elements shown as a single component may be replaced with multiple components, and elements shown as multiple components may be replaced with a single component. The drawings are not to scale and the proportion of certain elements may be exaggerated for the purpose of illustration.
Figure 1 is a schematic drawing illustrating a side view of one embodiment of a cabinet 100 in a first configuration;
Figure 2 is a schematic drawing illustrating a side view of the cabinet 100 in a second configuration;
Figure 3 is a perspective view of one specific embodiment of a cabinet 200 in a first configuration;
Figure 4 is a perspective view of the cabinet 200 in a second configuration;
Figure 5 is a perspective view of another specific embodiment of a cabinet 300 in a first configuration; and
Figure 6 is a perspective view of the cabinet 300 in a second configuration.

### DETAILED DESCRIPTION

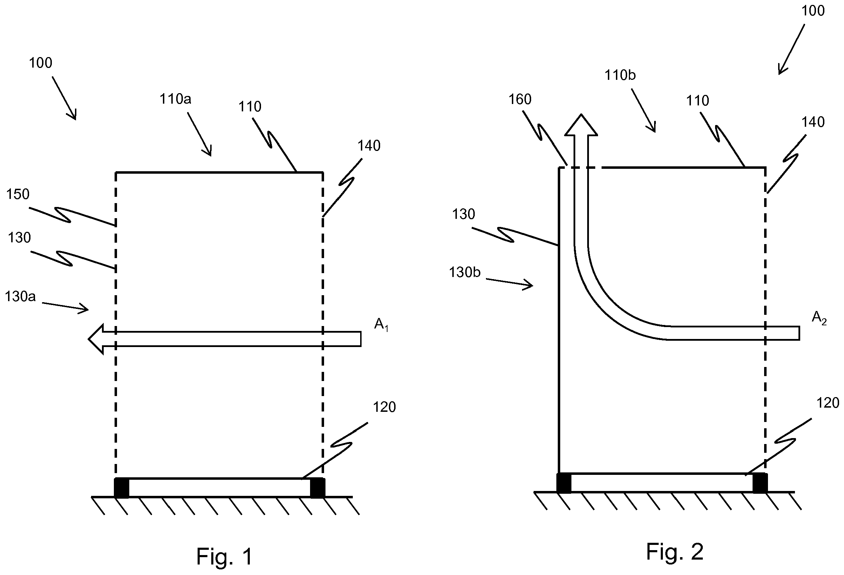

Figure 1 is a schematic drawing illustrating a side view of a cabinet 100 in a first configuration. The cabinet 100 is configured to house an article (not shown) that may require cooling. The cabinet 100 includes a top panel 110, a bottom panel 120, and a plurality of sidewalls connected to the top panel 110 and bottom panel 120. The plurality of sidewalls includes a first sidewall 130 that may be used as a rear sidewall of the cabinet. Therefore, the first sidewall 130 may be referred to as a rear sidewall. However, it should be understood that the orientation of the cabinet may be changed, and any description of a rear sidewall is not meant to limit the cabinet to any particular orientation.

The cabinet 100 also includes an air inlet 140. In the illustrated embodiment, the air inlet 140 is disposed opposite the first sidewall 130. In alternative embodiments (not shown), the air inlet may be disposed at the bottom of the cabinet, or any of the sides. In one embodiment, the air inlet 140 comprises one or more apertures in a panel of the cabinet 100. For example, the air inlet may be formed by a plurality of perforations in a panel. Alternatively, the air inlet 140 may be formed by completely omitting a sidewall or the bottom panel.

In the first configuration shown in Figure 1, the top panel 110 is in a closed configuration 110a and the first sidewall 130 is in an opened configuration 130a. The opened configuration of the first sidewall 130 is caused by the exposure of a side air outlet 150 in the first sidewall 130. The first configuration results in a first air flow Ai from the air inlet 140 through the side air outlet 150.

The side air outlet 150 includes one or more apertures in the first sidewall 130. In one specific embodiment, the side air outlet 150 includes a plurality of perforations in the first sidewall 130. Although the illustrated embodiment shows the side air outlet 150 extending along the entire height of the first sidewall 130, it should be understood that the side air outlet may have any dimensions and take any shape.

Figure 2 is a schematic drawing illustrating a side view of the cabinet 100 in a second configuration. The components of the cabinet 100 remain the same. However, in the second configuration, the top panel 110 is in an opened configuration 110b and the first sidewall 130 is in a closed configuration 130b. The opened configuration of the top panel 110 is caused by the exposure of a top air outlet 160 in the top panel 110. The second configuration results in a second air flow A 2from the air inlet 140 through the top air outlet 160.

The top air outlet 160 includes one or more apertures in the top panel 110. In one specific embodiment, the top air outlet 160 includes a plurality of perforations in the top panel 110. Although the illustrated embodiment shows the top air outlet 160 extending along a small portion of the top panel 110, it should be understood that the side air outlet may have any dimensions and take any shape.

In a first embodiment of the cabinet 100 shown in Figures 1 and 2, the top panel 110 and bottom panel 120 are fixedly connected to the plurality of sidewalls. The fixed connections may be permanent (e.g. through riveting, welding, brazing, etc.) or not permanent (e.g. through screws, nuts and bolts, etc.). The top panel 110 and bottom panel 120 may be directly connected to the plurality of sidewalls 130, or they may be connected via a frame of the cabinet (not shown).

In the first embodiment, the top panel 110 always includes the top air outlet 160 and the first sidewall 130 always includes the side air outlet 150. The cabinet 100 may be converted to the first configuration shown in Figure 1 by securing a cover (not shown) to the top panel 110, over the top air outlet 160, thereby obstructing air flow through the top air outlet 160. The cabinet 100 may be converted to the second configuration shown in Figure 2 by securing a cover (not shown) to the first sidewall 130, over the side air outlet 150, thereby obstructing air flow through the side air outlet 150.

In a second embodiment of the cabinet 100 shown in Figures 1 and 2, at least a portion of the top panel 110 is removably connected to the plurality of sidewalls. Likewise, at least a portion of the first sidewall 130 is removably connected to the top panel 110 and the bottom panel 120. The top panel 110 and bottom panel 120 may be directly connected to the plurality of sidewalls 130, or they may be connected via a frame of the cabinet (not shown).

In the second embodiment, the top panel 110 includes a first, solid top panel, and a second top panel having the top air outlet disposed therein. Likewise, the first sidewall 130 includes a first, solid sidewall, and a second sidewall having the side air outlet disposed therein. The cabinet 100 may be converted to the first configuration shown in Figure 1 by securing the first, solid top panel and the second sidewall to the cabinet 100. In the first configuration, the second top panel, and the first, solid sidewall are not employed.

The cabinet 100 may be converted to the second configuration shown in Figure 2 by securing the second top panel and the first, solid sidewall to the cabinet 100. In the second configuration, the first, solid top panel, and the second sidewall are not employed.

In one embodiment, the cabinet 100 is a cabinet for cabinet electronic equipment. In such an embodiment, the cabinet may include shelves, or other fixtures for securing the equipment. The cabinet 100 may be constructed of sheet steel, aluminum, or other metals. Alternatively, the cabinet 100 may be constructed of a polymeric material. It should be understood that the components of the cabinet may be constructed of the same or different materials.

In one embodiment, one or more exhaust fans may be employed to control the air flow. Although various air inlets and air outlets are described above, it should be understood that the direction of the airflow may be reversed. Accordingly, what is described as an air inlet may function as an air outlet. Likewise, what is described as an air outlet may function as an air inlet. Therefore, the terms "inlet" and "outlet" should not be taken as limiting the direction of airflow.

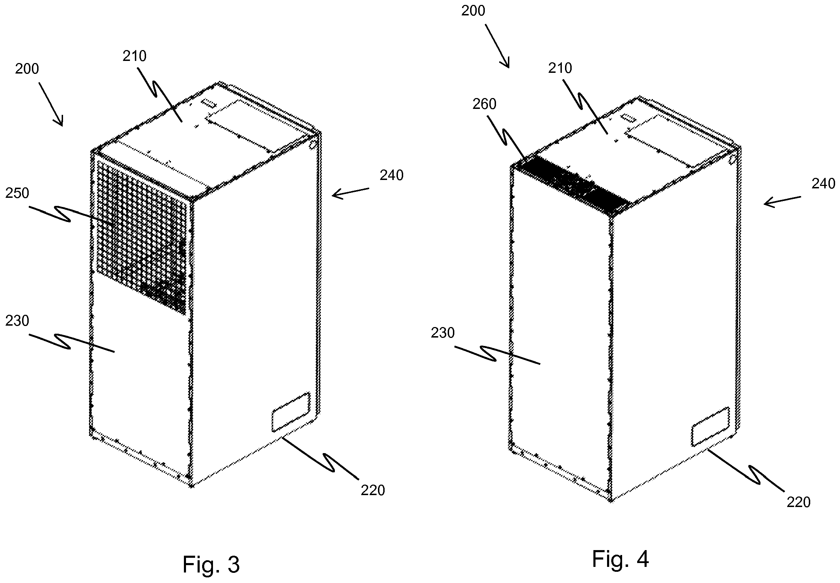

Figures 3 and 4 are perspective views of one embodiment of a cabinet 200 in a first and second configuration, respectively. The cabinet 200 is one specific embodiment of the cabinet 100 and functions in the same manner.

The cabinet 200 includes a top panel 210, a bottom panel 220, and a plurality of sidewalls connected to the top panel 210. The plurality of sidewalls includes a first sidewall 230 that may be used as a rear sidewall of the cabinet. The cabinet 200 also includes an air inlet 240. In the illustrated embodiment, the air inlet 240 is disposed opposite the first sidewall 230. In alternative embodiments (not shown), the air inlet may be disposed at the bottom of the cabinet, or any of the sides. In one embodiment, the air inlet 240 is one or more apertures in a panel of the cabinet 200. Alternatively, the air inlet 240 may be formed by omitting a sidewall or the bottom panel completely.

The cabinet further includes a side air outlet 250 and a top air outlet 260. The air outlets 250, 260 are shown as perforations in square or rectangular formations. However, it should be understood that the perforations may be in any formation and have any dimension. In an alternative embodiment (not shown), the air outlets may be a single aperture.

The cabinet 200 may be converted to the first configuration or the second configurations by the various manners described above with reference to the cabinet 100 shown in Figures 1 and 2. Likewise, the cabinet 200 includes the same alternative embodiments discussed above with reference to the cabinet 100.

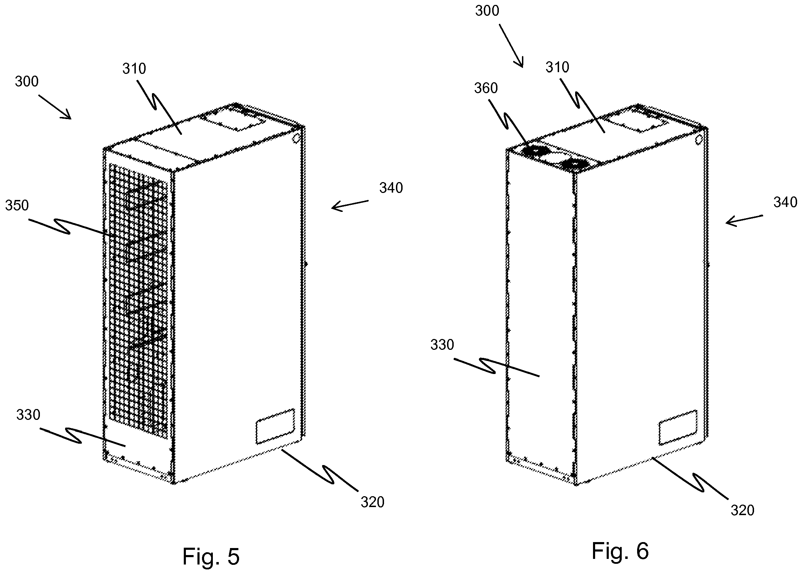

Figures 5 and 6 are perspective views of an alternative embodiment of a cabinet 300 in a first and second configuration, respectively. The cabinet 300 is one specific embodiment of the cabinet 100 and functions in the same manner.

The cabinet 300 includes a top panel 310, a bottom panel 320, and a plurality of sidewalls connected to the top panel 310. The plurality of sidewalls includes a first sidewall 330 that may be used as a rear sidewall of the cabinet. The cabinet 300 also includes an air inlet 340. In the illustrated embodiment, the air inlet 340 is disposed opposite the first sidewall 330. In alternative embodiments (not shown), the air inlet may be disposed at the bottom of the cabinet, or any of the sides. In one embodiment, the air inlet 340 is one or more apertures in a panel of the cabinet 300. Alternatively, the air inlet 340 may be formed by omitting a sidewall or the bottom panel completely.

The cabinet further includes a side air outlet 350 and a top air outlet 360. The side air outlet 350 is shown as a plurality of perforations in a rectangular formation, and the top air outlet 360 is shown as a plurality of perforations in a pair of circular formations. However, it should be understood that the perforations may be in any formation and have any dimension. In an alternative embodiment (not shown), the air outlets may be a single aperture.

The cabinet 300 may be converted to the first configuration or the second configurations by the various manners described above with reference to the cabinet 100 shown in Figures 1 and 2. Likewise, the cabinet 300 includes the same alternative embodiments discussed above with reference to the cabinet 100.

To the extent that the term "includes" or "including" is used in the specification or the claims, it is intended to be inclusive in a manner similar to the term "comprising" as that term is interpreted when employed as a transitional word in a claim. Furthermore, to the extent that the term "or" is employed (e.g., A or B) it is intended to mean "A or B or both." When the applicants intend to indicate "only A or B but not both" then the term "only A or B but not both" will be employed. Thus, use of the term "or" herein is the inclusive, and not the exclusive use. See, Bryan A. Garner, A Dictionary of Modern Legal Usage 624 (2d. Ed. 1995). Also, to the extent that the terms "in" or "into" are used in the specification or the claims, it is intended to additionally mean "on" or "onto." Furthermore, to the extent the term "connect" is used in the specification or claims, it is intended to mean not only "directly connected to," but also "indirectly connected to" such as connected through another component or components.

## Claims

1. A cabinet (100) configured to house an article that requires cooling, the cabinet (100) comprising:
a top panel (110b) having a top air outlet (160) disposed therein;
a removable top cover configured to be secured to the top panel (110b) over the top air outlet (160), thereby obstructing air flow through the top air outlet (160) a plurality of sidewalls (130) connected to the top panel (110b) the plurality of sidewalls (130) including a rear wall having a rear air outlet (150) disposed therein; and
a removable rear cover configured to be secured to the rear wall over the rear air outlet (150), thereby obstructing air flow through the rear air outlet (150), wherein, in a first configuration, the removable top cover is secured to the top panel over the top air outlet (160) such that that the top panel (110) is in a closed configuration (110a) and the rear outlet (150) of the rear wall is in an opened configuration (130a), or wherein, in a second configuration, the top panel (110) is in an opened configuration (110b) and the rear cover is secured over the rear outlet (150) of the rear wall such that it is in a closed configuration (130b).

2. The cabinet of claim 1, further comprising a front air inlet (140) opposite the rear air outlet (150), or a bottom air inlet opposite the top air outlet (160).

3. The cabinet of claim 1, wherein the top air outlet (160) includes a plurality of perforations disposed in the top panel (110), or the rear air outlet (150) includes a plurality of perforations disposed in the rear wall.

4. The cabinet of claim 1, further comprising a bottom panel (120) or at least one shelf disposed therein.

5. A cabinet (100) configured to house an article that requires cooling, the cabinet (100) comprising:
a frame;
a first top panel (110b) removably connected to the frame, the first top panel (110) having a top air outlet (160) disposed therein;
a second top panel, (110a), wherein the second top panel is solid and wherein the second top panel is configured to be removably connected to the frame to replace the first top panel (110b) a plurality of sidewalls (130) removably connected to the frame, the plurality of sidewalls (130) including at least a first rear wall and a second rear wall,
wherein the first rear wall (130a) has a rear air outlet (150) disposed therein,
wherein the second rear wall (130b) is a solid wall and wherein the second rear wall is configured to be removably connected to the frame to replace the first rear wall; (130a); and
wherein, in a first configuration, the first top panel (110b) is used in combination with the second rear wall (130b), or wherein, in a second configuration, the second top panel (110a) is used in combination with the first rear wall (130a).

6. The cabinet of claim 5, further comprising an exhaust fan disposed therein.

## Patentansprüche

1. Gehäuse (100), das zum Aufnehmen eines Artikels konfiguriert ist, der eine Kühlung erfordert, wobei das Gehäuse (100) Folgendes aufweist:
eine obere Platte (110b) mit einem darin angeordneten oberen Luftauslass (160);
eine entfernbare obere Abdeckung, die so konfiguriert ist, dass sie an der oberen Platte (110b) über dem oberen Luftauslass (160) befestigt ist, wodurch ein Luftfluss durch den oberen Luftauslass (160) behindert wird;
eine Vielzahl von Seitenwänden (130), die mit der oberen Platte (110b) verbunden sind, wobei die Vielzahl von Seitenwänden (130) eine hintere Wand mit einem hinteren Luftauslass (150) aufweist, der darin angeordnet ist; und
eine entfernbare hintere Abdeckung, die so konfiguriert ist, dass sie an der hinteren Wand über dem hinteren Luftauslass (150) befestigt ist, wodurch ein Luftfluss durch den hinteren Luftauslass (150) behindert wird, wobei in einer ersten Konfiguration die entfernbare obere Abdeckung an der oberen Platte über dem oberen Luftauslass (160) befestigt ist, so dass die obere Platte (110) in einer geschlossenen Konfiguration (110a) ist und der hintere Auslass (150) der hinteren Wand in einer geöffneten Konfiguration (130a) ist, oder wobei in einer zweiten Konfiguration die obere Platte (110) in einer geöffneten Konfiguration (110b) ist und die hintere Abdeckung über dem hinteren Auslass (150) der hinteren Wand befestigt ist, so dass dieser in einer geschlossenen Konfiguration (130b) ist.

2. Gehäuse nach Anspruch 1, welches weiter einen vorderen Lufteinlass (140) gegenüberliegend zum hinteren Luftauslass (150) aufweist, oder einen unteren Lufteinlass gegenüberliegend zum oberen Luftauslass (160) aufweist.

3. Gehäuse nach Anspruch 1, wobei der obere Luftauslass (160) eine Vielzahl von Perforationen aufweist, die in der oberen Platte (110) angeordnet sind, oder wobei der hintere Luftauslass (150) eine Vielzahl von Perforationen aufweist, die in der hinteren Wand angeordnet sind.

4. Gehäuse nach Anspruch 1, welches weiter eine untere Platte (120) oder mindestens eine darin angeordnete Ablageplatte aufweist.

5. Gehäuse (100), das zum Aufnehmen eines Artikels konfiguriert ist, der eine Kühlung erfordert, wobei das Gehäuse (100) Folgendes aufweist:
einen Rahmen;
eine erste obere Platte (110b), die in entfernbarer Weise mit dem Rahmen verbunden ist, wobei die erste obere Platte (110b) einen darin angeordneten oberen Luftauslass (160) hat;
eine zweite obere Platte (110a), wobei die zweite obere Platte durchgehend ist und wobei die zweite obere Platte so konfiguriert ist, dass sie in entfernbarer Weise mit dem Rahmen verbunden ist, um die erste obere Platte (110b) zu ersetzen;
eine Vielzahl von Seitenwänden (130), die in entfernbarer Weise mit dem Rahmen verbunden sind, wobei die Vielzahl von Seitenwänden (130) zumindest eine erste hintere Wand und eine zweite hintere Wand aufweisen, wobei die erste hintere Wand (130a) einen hinteren Luftauslass (150 hat, der darin angeordnet ist,
wobei die zweite hintere Wand (130b) eine durchgezogene Wand ist, und wobei die zweite hintere Wand so konfiguriert ist, dass sie in entfernbarer Weise mit dem Rahmen verbunden ist, um die erste hintere Wand (130a) zu ersetzen; und
wobei in einer ersten Konfiguration die erste obere Platte (110b) in Kombination mit der zweiten hinteren Wand (130b) in Verwendung ist, oder wobei in einer zweiten Konfiguration die zweite obere Platte (110a) in Kombination mit der ersten hinteren Wand (130a) in Verwendung ist.

6. Gehäuse nach Anspruch 5, welches weiter einen darin angeordneten Entlüftungsventilator aufweist.

## Revendications

1. Meuble (100) configuré pour héberger un article qui nécessite un refroidissement, le meuble (100) comprenant :
un panneau supérieur (110b) ayant une évacuation d'air supérieure (160) agencée en lui ;
un couvercle supérieur amovible configuré pour être fixé au panneau supérieur (110b) au-dessus de l'évacuation d'air supérieure (160), obstruant ainsi un flux d'air à travers l'évacuation d'air supérieure (160),
une pluralité de parois latérales (130) connectées au panneau supérieur (110b), la pluralité de parois latérales (130) comportant une paroi arrière ayant une évacuation d'air arrière (150) placée en elle ; et
un couvercle arrière amovible configuré pour être fixé à la paroi arrière sur l'évacuation d'air arrière (150), obstruant ainsi un flux d'air à travers l'évacuation d'air arrière (150), dans lequel, dans une première configuration, le couvercle supérieur amovible est fixé au panneau supérieur sur l'évacuation d'air supérieure (160) de sorte que le panneau supérieur (110) est dans une configuration fermée (110a) et l'évacuation arrière (150) de la paroi arrière est dans une configuration ouverte (130a), ou dans lequel, dans une deuxième configuration, le panneau supérieur (110) est dans une configuration ouverte (110b) et le couvercle arrière fixé sur l'évacuation arrière (150) de la paroi arrière de sorte qu'elle est dans une configuration fermée (130b).

2. Meuble selon la revendication 1, comprenant en outre, une admission d'air avant (140) opposée à l'évacuation d'air arrière (150), ou une admission d'air inférieure opposée à l'évacuation d'air supérieure (160).

3. Meuble selon la revendication 1, dans lequel l'évacuation d'air supérieure (160) comporte une pluralité de perforations placée dans le panneau supérieur (110), ou l'évacuation d'air arrière (150) comporte une pluralité de perforations placée dans la paroi arrière.

4. Meuble selon la revendication 1, comprenant en outre un panneau inférieur (120) ou au moins une étagère placée en lui.

5. Meuble (100) configuré pour héberger un article qui nécessite un refroidissement, le meuble (100) comprenant :
un cadre ;
un premier panneau supérieur (110b), connecté de façon amovible au cadre, le premier panneau supérieur (110b) ayant une évacuation d'air supérieure (160) placée en lui ;
un deuxième panneau supérieur (110a), dans lequel le deuxième panneau supérieur est solide et dans lequel le deuxième panneau supérieur est configuré pour être connecté de façon amovible au cadre pour remplacer le premier panneau supérieur (110b),
une pluralité de parois latérales (130) connectées au cadre, la pluralité de parois latérales (130) comportant au moins une première paroi arrière et une deuxième paroi arrière,
dans lequel la première paroi arrière (130a) a une évacuation d'air arrière (150) placée en elle,
dans lequel la deuxième paroi arrière (13ba) est une paroi solide et dans lequel la deuxième paroi arrière est configurée pour être connectée de façon amovible au cadre pour remplacer la première paroi arrière (130a) ; et
dans lequel, dans une première configuration, le premier panneau supérieur (110b) est utilisé en combinaison avec la deuxième paroi arrière (130b), ou dans lequel, dans une deuxième configuration, le deuxième panneau supérieur (110a) est utilisé en combinaison avec la première paroi arrière (130a).

6. Meuble selon la revendication 5, comprenant en outre un ventilateur extracteur placé en lui.
